# EUROPÄISCHE PATENTSCHRIFT

(11) **EP 4 035 213 B1**
(45) Veröffentlichungstag und Bekanntmachung des Hinweises auf die Patenterteilung: **09.09.2026**
(21) Anmeldenummer: 20780183.8
(22) Anmeldetag: 24.09.2020
(51) Int. Cl.: H10H 20/01, H10H 20/831, H10N 80/10, H10D 62/85

(54) **GUNNDIODE UND VERFAHREN ZU DEREN HERSTELLUNG**
GUNN DIODE AND METHOD FOR PRODUCING SAME
DIODE GUNN ET SON PROCÉDÉ DE PRODUCTION

(30) Priorität: 25.09.2019 DE 102019125847
(43) Veröffentlichungstag der Anmeldung: 03.08.2022
(73) Patentinhaber: Technische Universität Darmstadt, 64289 Darmstadt (DE)
(72) Erfinder: YILMAZOGLU, Oktay, 64846 Groß-Zimmern (DE); HAJO, Ahid, 64287 Darmstadt (DE)
(74) Vertreter: LifeTech IP Spies & Behrndt Patentanwälte PartG mbB
(86) Internationale Anmeldenummer: PCT/EP2020/076715
(87) Internationale Veröffentlichungsnummer: WO 2021/058645

(56) Entgegenhaltungen:
- CN-A- 104 681 721
- CN-A- 105 206 684
- FR-A1- 2 181 466
- US-A1- 2004 130 002

## Beschreibung

Die vorliegende Erfindung bezieht sich auf eine Gunndiode und ein Verfahren zur Herstellung einer Gunndiode und insbesondere auf eine Galiumnitridbasierte Gunndiode mit hohen Ausgangsleistungen im Hochfrequenzbereich für aktive bildgebende Scanner.

### HINTERGRUND

Der Gunn-Effekt wurde erfolgreich in GaAs- oder InP-basierten Halbleiterbauelemente genutzt, um Hochfrequenzsignale zu erzeugen. Diese Halbleitermaterialien weisen Materialeigenschaften wie Energiebandverläufe, Ladungsträgergeschwindigkeiten und -beweglichkeiten auf, die den Elektronentransfer des Gunn-Effektes in Gang setzen können.

Gunndiode nutzen diesen Effekt, indem durch geeignete Beschaltung (z.B. durch Anlegen einer entsprechenden Versorgungsspannung) bewirkt wird, dass Elektronen sich aufstauen und in Schüben (wie Wellen) durch die Diode wandern. Dies wiederum resultiert in einer Erzeugung und anschließenden Abstrahlung elektromagnetischer Wellen entsprechend dieser Frequenz.

Insbesondere für sehr hohe Frequenzen (z.B. im Terahertzbereich) haben bekannten GaAs-basierte Halbleiterbauelemente eine Reihe von Nachteilen. Diese sind darin begründet, dass Sättigungsgeschwindigkeit für Elektronen sowie Elektronentransferzeiten für diese hohen Frequenzen zu gering sind. Somit sind diese Halbleiterbauelement für Frequenzen im Terahertzbereich kaum einsetzbar. Weiterhin ist die elektrische Schwellfeldstärke für den sog. "Elektronentransfereffekt" bzw. die Energiebandlücke zu gering für hohe Ausgangsleistungen.

Galliumnitrid-basierte Gunndioden sind vorteilhaft, da das thermisch gut leitfähige Substrat (GaN) stabile negative differenzielle Widerstände erzeugen kann. Optional sind auch verwandte Materialien wie Aluminium-Indium-Galliumnirid (AlInGaN) Materialien als aktive Schicht möglich.

Da andererseits ein wachsender Bedarf nach THz-Strahlungsquellen besteht, ist es wünschenswert Alternativen zu den GaAs-basierten Halbleiterbauelemente zu finden. Insbesondere ist es wünschenswert weitere Materialien für die Erzeugung von Hochfrequenzsignalen effizient nutzbar zu machen.

Das Dokument FR2181466 A1 offenbart eine Gunn-Diode mit geneigten Seitenflächen, auf denen Seitenkontakte ausgebildet sind.

### KURZBESCHREIBUNG DER ERFINDUNG

Zumindest ein Teil der obengenannten Probleme wird durch eine Gunndiode nach Anspruch 1, einen Scanner nach Anspruch 10 und ein Verfahren zu deren Herstellung nach Anspruch 11 gelöst. Die abhängigen Ansprüche definieren weitere vorteilhafte Ausführungsformen für die Gegenstände der unabhängigen Ansprüche.

Die vorliegende Erfindung bezieht sich auf eine Gunndiode mit einer ersten Kontaktschicht und einer zweiten Kontaktschicht. Die Gunndiode umfasst weiter eine aktive Schicht basierend auf einem Galliumnitrid (GaN)-Halbleitermaterial mit einer Grundfläche und einer dazu nicht-parallelen Seitenfläche. Die erste Kontaktschicht kontaktiert die Seitenfläche elektrisch, um einen Seitenkontakt zu bilden. Die zweite Kontaktschicht bildet einen elektrischen Kontakt für die Grundfläche, sodass ein Maximum der elektrischen Feldstärke beim Anlegen einer elektrischen Spannung zwischen der ersten Kontaktschicht und der zweiten Kontaktschicht an dem Seitenkontakt sich bildet.

Bei den konventionellen GaAs-Schaltern werden die Elektronen im Leitungsband vom Valenzband bzw. sogenannten "Deep Levels" zwischen dem Valenz- und Leitungsband erzeugt. Die Galliumnitrid-Gunndioden gemäß Ausführungsbeispielen transferieren hingegen Elektronen vom Haupttal im Leitungsband zu einem Satellitental, welches erneut in dem Leitungsband ist. Durch die Nutzung der GaN-Materialien sind die Elektronenmassen im Satellitental sehr hoch und verursachen eine deutliche Widerstandserhöhung. Das führt zu einem schnellen Stromabfall. Außerdem kann dieser Transfer in sehr kurzer Zeit (z.B. unterhalb von Picosekunden) erfolgen und führt daher zu schnellen Stromänderungen. Daher kann eine THz-Strahlung hoher Leistung erzeugt werden.

Die Seitenkontaktierung hat den Effekt, dass die Feldstärke am Seitenkontakt, größer ist als beispielsweise in anderen Bereichen. Daher wird der Gunn-Effekt vorwiegend in dem Seitenbereich ab einer bestimmten Tiefe wirksam, d.h. dort, wo die Feldstärke für den Elektronentransfer ausreicht. Ein parasitärer Strom, der nicht zum Gunn-Effekt beiträgt und in einem inneren Bereich, innerhalb der Kontur des Seitenbereiches, durch die aktive Schicht fließt, stört diesen Gunn-Effekt nicht weiter.

Optional umfasst Gunndiode ein Substrat, das zwischen der zweiten Kontaktschicht und der Grundfläche ausgebildet ist und insbesondere Galliumnitrid aufweist.

Optional umfasst Gunndiode ein Substrat, das zwischen der zweiten Kontaktschicht und der Grundfläche ausgebildet ist und Siliziumkarbid (SiC), Silizium oder Saphir aufweist.

Optional umfasst die aktive Schicht entlang einer der Grundfläche gegenüberliegenden Vorderfläche einen elektrisch leitfähigen Bereich, der insbesondere durch einen hochdotierten Bereich (deutlich höher dotiert als die restliche Schicht) gebildet wird.

Optional ist die Seitenfläche abgeschrägt oder senkrecht zur Grundfläche ausgebildet und verbindet die Grundfläche mit der Vorderfläche.

Optional umfasst die Gunndiode zumindest eine der folgenden Passivierungen: eine Zwischenpassivierung zwischen der Vorderfläche und der ersten Kontaktschicht; eine Substratpassivierung, die seitlich neben der aktiven Schicht zwischen der ersten Kontaktschicht und dem Substrat gebildet ist.

Optional kontaktiert (elektrisch) die erste Kontaktschicht die aktive Schicht nur entlang der Seitenfläche.

Optional umfasst Gunndiode ein optisches Fenster als optischen Zugang zur Vorderfläche, um optische Anregungen im Bereich des Seitenkontaktes zu ermöglichen bzw. zu unterstützen.

Optional ist der Seitenkontakt als ein ohmscher Seitenkontakt oder als ein Schottky-Seitenkontakt gebildet. Ein ohmscher Kontakt ist vorliegend durch einen Übergangsbereich zwischen Metall und Halbleiter definiert, der sich wie ein ohmscher Widerstand verhält. Im Gegensatz zu einem Schottky-Kontakt hat er beispielsweise keine oder nur eine vernachlässigbare Gleichrichterfunktion. Ein Schottky-Kontakt bezeichnet dementsprechend einen Metall-Halbleiter-Übergang, der eine gleichrichtende Wirkung aufweist und sich daher wie eine Diode verhält. In der Regel ist der Schottky-Kontakt ein scharfer, abrupter Übergang, während bei einem ohmschen Kontakt eine gewisse Materialvermischung (z.B. durch thermische Behandlung) vorliegt.

Optional hat zumindest eine der definierten Schichten eine der folgenden Ausdehnungen:
- die aktive Schicht eine Dicke im Bereich von 0,5 bis 5 µm,
- der leitfähige Bereich eine Dicke im Bereich von 10 - 200 nm,
- das Substrat eine Dicke im Bereich zwischen 10 und 400 µm.

Optional ist die erste Kontaktschicht und/oder die zweite Kontaktschicht durch eine Schichtfolge mit zumindest einem der folgenden Materialien gebildet ist: Titan, Aluminium, Gold. Sie können aber auch durch hochdotiertes Halbleitermaterial gebildet sein.

Ausführungsbeispiele beziehen sich auch auf einen bildgebenden Scanner mit einer zuvor definierten Gunndiode als THz-Strahlungsquelle.

Ausführungsbeispiele beziehen sich auch auf ein Verfahren zur Herstellung einer Gunndiode. Das Verfahren umfasst die folgenden Schritte:
- Bereitstellen einer zweiten Kontaktschicht;
- Ausbilden einer aktiven Schicht basierend auf einem Galliumnitrid (GaN)-Halbleitermaterial mit einer Grundfläche und einer dazu nicht-parallelen Seitenfläche, wobei die zweite Kontaktschicht einen elektrischen Kontakt für die Grundfläche bildet (optional sind auch verwandte Materialien wie Aluminium-Indium-Galliumnirid (AlInGaN) Materialien als aktive Schicht möglich);
- Bilden eines elektrischen Seitenkontaktes zwischen der Seitenfläche und einer ersten Kontaktschicht, sodass ein Maximum der elektrische Feldstärke beim Anlegen einer elektrischen Spannung zwischen der ersten Kontaktschicht und der zweiten Kontaktschicht an dem Seitenkontakt sich bildet.

Optional umfasst das Verfahren weiter:
- Bilden der zweiten Kontaktschicht auf einem Substrat, wobei das Ausbilden einer aktiven Schicht auf einer Oberfläche des Substrats erfolgt, die gegenüberliegend zu der zweiten Kontaktschicht ist;
- Ausbilden einer Zwischenpassivierung auf der aktiven Schicht;
- Ausbilden einer ersten Kontaktschicht auf der Zwischenpassivierung und zumindest teilweise auf dem Substrat seitlich neben der aktiven Schicht, wobei optional zwischen der ersten Kontaktschicht und dem Substrat seitlich neben der aktiven Schicht eine Substratpassivierung ausgebildet wird.

Optional umfasst das Verfahren weiter: Freilegen zumindest eines Teils der ersten Kontaktschicht gegenüberliegend der aktiven Schicht, um ein optisches Fenster für eine optische Bestrahlung zur Unterstützung der Gunndiode bereitzustellen.

Optional umfasst das Verfahren weiter: ein Bereitstellen eines Lichtleiters für eine optische Zuleitung von Photonen in die aktive Schicht in einer Umgebung des Seitenkontaktes.

Vorteile von Ausführungsbeispielen lassen sich wie folgt zusammenfassen:
- Die Seitenkontaktierung gemäß Ausführungsbeispielen erhöht die Stabilität und ermöglicht auch die Erzeugung von breitbandigen THz-Strahlungen (im Bereich zwischen 50 GHz bis mehreren THz, z.B. bis zu 5 THz oder 10 THz oder noch mehr).
- Die Nitrid-Materialien erlauben einen Betrieb bei viel höheren Frequenzen und Leistungen, da unter anderem die erreichbare Sättigungsgeschwindigkeit für Elektronen sehr hoch sind (für Galliumnitrid sind sie zumindest zwei Mal höher als für Galliumarsenid), elektrische Schwellfeldstärken für den sogenannten Elektronentransfereffekt viel höher sind (bei den genutzten Galliumnitrid ist dieser 50 Mal höher als für Galliumarsenid) sowie eine große Energiebandlücke vorhanden ist.
- Damit können diese Bauteile auch als kurzwellige optische Dioden und Halbleiterlaser genutzt werden, die in Bereichen wie der Kommunikation, Lichttechnik, Multimedia usw. Anwendung finden.
- Während Signalquellen auf der Basis von Galliumarsenid- und InP-Bauelementen jeweils Grenzfrequenzen von 100 GHz bzw 200 GHz (für die Grundmode) aufweisen, liegen die berechneten Grenzwerte für Galliumnitriddioden bei über 700 GHz. Berechnungen hierzu wurden für Gunndioden auf der Basis von Galliumnitrid durchgeführt.
- Photomodulierte Feldemissionsströme von GaN-Feldemitterspitzen wurden mit niedrigen Frequenzen erreicht.
- Weiterhin hat die neue Galliumnitrid-Gunndiode gemäß Ausführungsbeispielen gegenüber Galliumarsenid-Schaltern den Vorteil, dass die viel größere Stromänderungen stabil und schnell geschaltet werden können. Da die Ausgangsleistung proportional zum Quadrat der Stromänderung ist (P ≃*Δ* I²), lassen sich die gewünschten hohen Ausgangsleistungen erreichen.

### KURZBESCHREIBUNG DER FIGUREN

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt einen Querschnitt durch eine Gunndiode gemäß einem Ausführungsbeispiel der vorliegenden Erfindung.
- Fig. 2A, 2B: zeigen eine Gunndiode nach einem weiteren Ausführungsbeispiel in einer Querschnittsansicht und einer Draufsicht.
- Fig. 3: zeigt eine Gunndiode gemäß einem weiteren Ausführungsbeispiel.
- Fig. 4: zeigt ein Flussdiagramm für ein Verfahren zur Herstellung der genannten Gunndioden.

### DETAILLIERTE BESCHREIBUNG

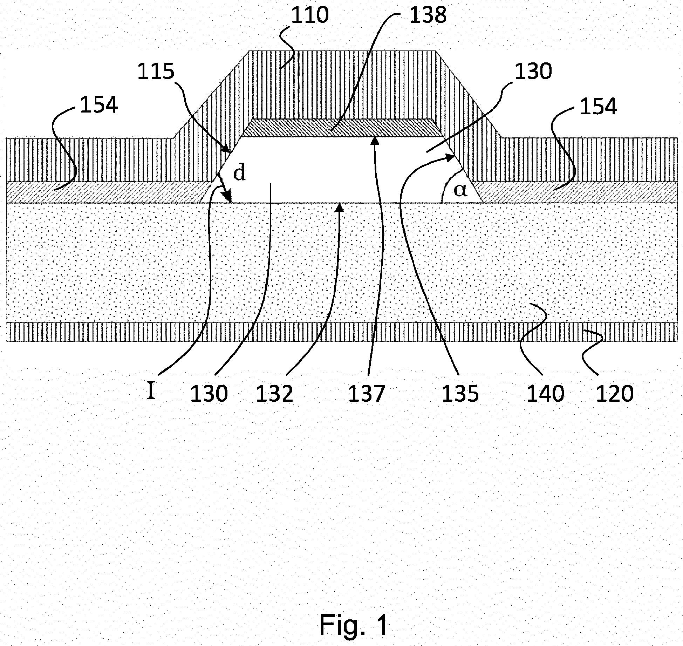

**Fig. 1** zeigt ein Ausführungsbeispiel für die Gunndiode. Die Gunndiode umfasst eine aktive Schicht 130, die zwischen einer ersten Kontaktschicht 110 und einem Substrat 140, welches auf einer Rückseite durch die zweite Kontaktschicht 120 kontaktiert wird, ausgebildet ist. Die aktive Schicht 130 ist mit einer Grundfläche 132 auf dem Substrat 140 angeordnet und gegenüberliegend zur Grundfläche 132 bildet die aktive Schicht 130 eine Vorderfläche 137. Die Vorderfläche 137 und die Grundfläche 132 sind durch die Seitenfläche 135 verbunden. Die Seitenfläche 135 kann sich dabei vollständig um die aktive Schicht 130 herum erstrecken, wobei die erste Kontaktschicht 110 die Seitfläche 135 elektrisch kontaktiert, um den Seitenkontakt 115 zu bilden.

Entlang der Vorderfläche 137 umfasst die aktive Schicht 130 einen leitfähigen Bereich 138, der beispielsweise durch einen hochdotierten Bereich der aktiven Schicht 130 gebildet werden kann, wobei die Dotierung so gewählt werden kann, um eine gewünschte Leitfähigkeit einzustellen. Die elektrische Kontaktierung soll damit erleichtert werden.

In dem in der Fig. 1 gezeigten Ausführungsbeispiel ist auf dem Substrat 140 seitlich versetzt zur aktiven Schicht 130 eine Substratpassivierung 154 ausgebildet, die eine elektrische Isolierung zwischen der ersten Kontaktschicht 110 und dem Substrat 140 bereitstellt. In dem gezeigten Ausführungsbeispiel ist die Seitenfläche 135 geneigt zur Grundfläche 132 ausgebildet. So kann beispielsweise die Seitenfläche 135 relativ zur Grundfläche 132 einen Winkel α in einem Bereich zwischen 30° und 90° aufweisen. Der Winkel zwischen der Seitenfläche 135 und der Grundfläche 132 kann aber beliebig gewählt werden, z.B. ≤ 90° oder in einem Bereich zwischen 40° und 90°, oder ungefähr bei 60°.

Auf den leitfähigen Bereich 138 kann die erste Kontaktschicht 110 vollständig ausgebildet sein. Es ist aber auch möglich, dass die erste Kontaktschicht 110 sich seitlich neben der aktiven Schicht 130 horizontal weiter erstreckt. Wichtig ist, dass die erste Kontaktschicht 110 den Seitenkontakt 115 entlang der Seitenfläche 135 bildet.

Das THz-Signal wird in der aktiven Schicht 130 über eine Tiefe d erzeugt, und zwar vorwiegend in dem Bereich des Seitenkontaktes 115, da dort - beim Anlegen einer Spannung zwischen der ersten und der zweiten Kontaktschicht 110, 120 - die Entfernung zu dem Substrat 140 am geringsten ist (der kürzeste Strompfad "d" ist kleiner als die Schichtdicke der aktiven Schicht 130) und somit die erzeugte Feldstärke am größten ist. Als Folge wird dort auch der Stromfluss I, der das Wechselstromsignal erzeugt, eher (bei kleineren Betriebsspannungen) erreicht als in anderen Gebieten. Dadurch wird die Erzeugung von THz-Wellen mit hohen Leistungen ermöglicht (P ≃*Δ* I²). Das erzeugte THz-Signal kann zwischen der ersten Kontaktschicht 110 und der zweiten Kontaktschicht 120 von der Gunndiode abgegriffen werden.

Bei dem Ausführungsbeispiel der Fig. 1 sind immer noch parasitäre Ströme, die zum Gunn-Effekt nicht nennenswert beitragen, zwischen dem leitfähigen Bereich 138 und dem Substrat 140 möglich.

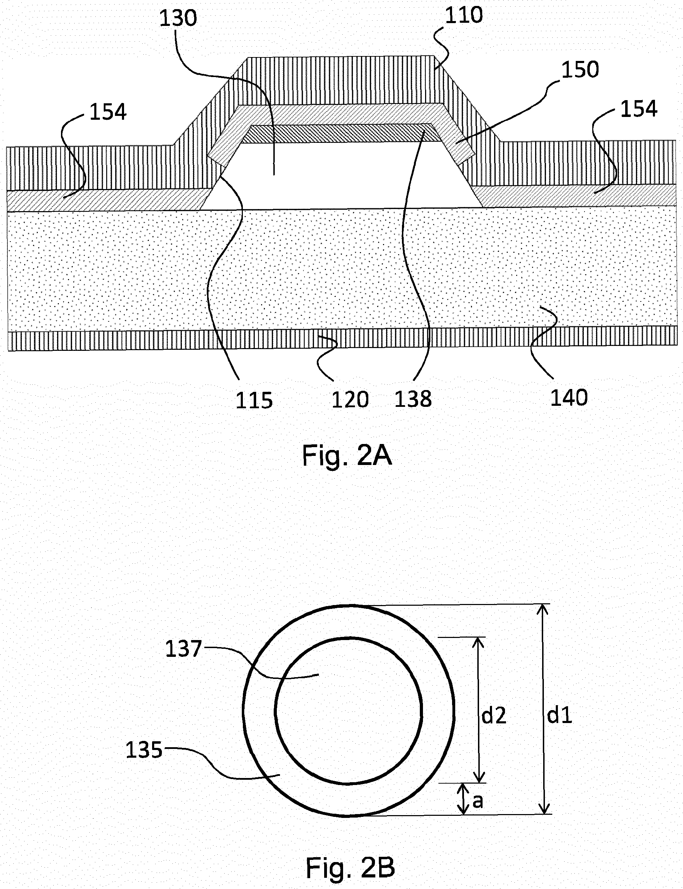

**Fig. 2A** zeigt eine Gunndiode nach einem weiteren Ausführungsbeispiel, bei dem mögliche parasitäre Ströme zwischen der ersten Kontaktschicht 110 und der aktiven Schicht 130 durch eine Zwischenpassivierung 150 minimiert werden.

Hierzu wird eine Zwischenpassivierung 150 zwischen der ersten Kontaktschicht 110 und dem leitfähigen Bereich 138 ausgebildet. Die Zwischenpassivierung 150 kann sich seitlich bis zu einem gewissen Grad auch entlang der Seitfläche 135 erstrecken und nur den Bereich des Seitenkontaktes 115 freilassen. Dann wird nur dort eine elektrische Kontaktierung der aktiven Schicht 130 bewirkt. Somit wird in dem Ausführungsbeispiel der Fig. 2 ein elektrischer Strom nur dort erzeugt, wo er für den Gunn-Effekt von Bedeutung ist.

**Fig. 2B** zeigt eine Draufsicht auf die erzeugten Gunndiode. Die aktive Schicht 130 umfasst beispielhaft eine runde Form, die entlang der Grundfläche einen Grunddurchmesser d1 und entlang der Vorderfläche 137 einen Vorderdurchmesser d2 aufweist. Der Zwischenbereich wird durch die Seitenfläche 135 gebildet, wobei die Ausdehnung relativ zu d1, d2 durch den Winkel α und somit der Stärke a gegeben ist. In diesem Teilbereich der Seitenfläche 135 wird das THz-Signal infolge des Gunn-Effekts erzeugt.

Die Gunndiode ist hier nur beispielhaft zirkular angegeben. Die Erfindung soll darauf nicht eingeschränkt werden. Jede beliebige andere Form ist ebenfalls möglich. Ebenso kann der Innenbereich mit dem Durchmesser d2 beliebig klein gewählt werden. Dadurch sind sehr kleine Gunndioden hoher Leistung bzw. Leistungsdichte herstellbar.

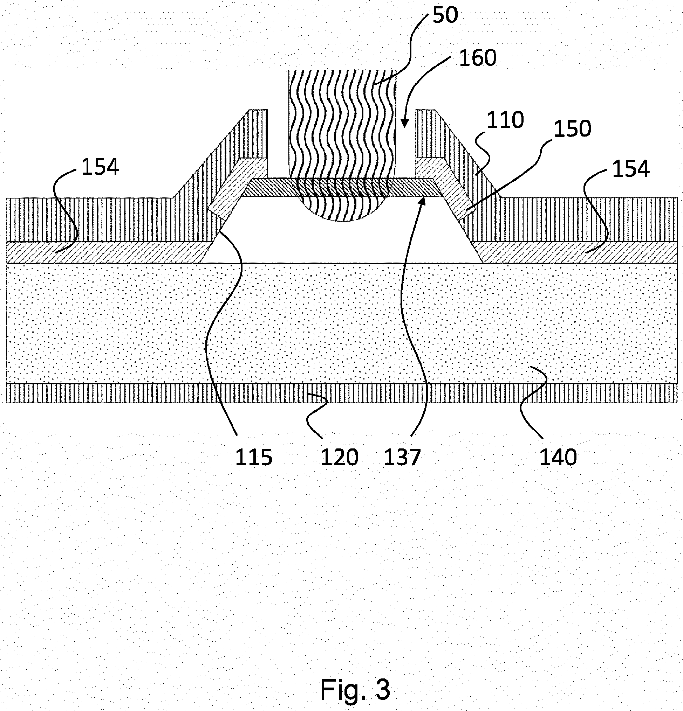

**Fig. 3** zeigt ein weiteres Ausführungsbeispiel für die Gunndiode, wobei in diesem Ausführungsbeispiel oberhalb der Vorderfläche 137 ein optisches Fenster 160 ausgebildet ist. Dazu kann beispielhaft die erste Kontaktschicht 110 oberhalb der Vorderfläche 137 (innerhalb der Seitenfläche 135) ganz oder teilweise geöffnet werden. Das resultierende optische Fenster 160 kann für eine Laserbestrahlung 50 genutzt werden. Die Laserbestrahlung 50 kann vollflächig erfolgen oder auch gezielt nur in dem Seitenbereich 135 erfolgen, wo der Gunn-Effekt wirkt.

Die optionale optische Anregung durch Photonen kann durch einen gepulsten oder ungepulsten Laser erfolgen und unterstützt den Gunn-Effekt (d.h. den Elektronentransfer zwischen den Tälern/Bändern). Für den genutzten Laser kann beispielsweise ein Infrarot-Laser genutzt werden, der eine Eindringtiefe von mehr als 2 µm aufweist. Jedoch soll die Erfindung nicht auf einen bestimmten Laser eingeschränkt werden. Es kann jeder beliebige andere Laser genutzt werden, der eine ausreichende Leistung bzw. optische Photonen mit einer gewünschten Energie erzeugen kann, die den Gunn-Effekt unterstützen (d.h. die Photonenenergie kann in Abhängigkeit der konkreten Energiebandlücken zwischen den genutzten Tälern eingestellt werden).

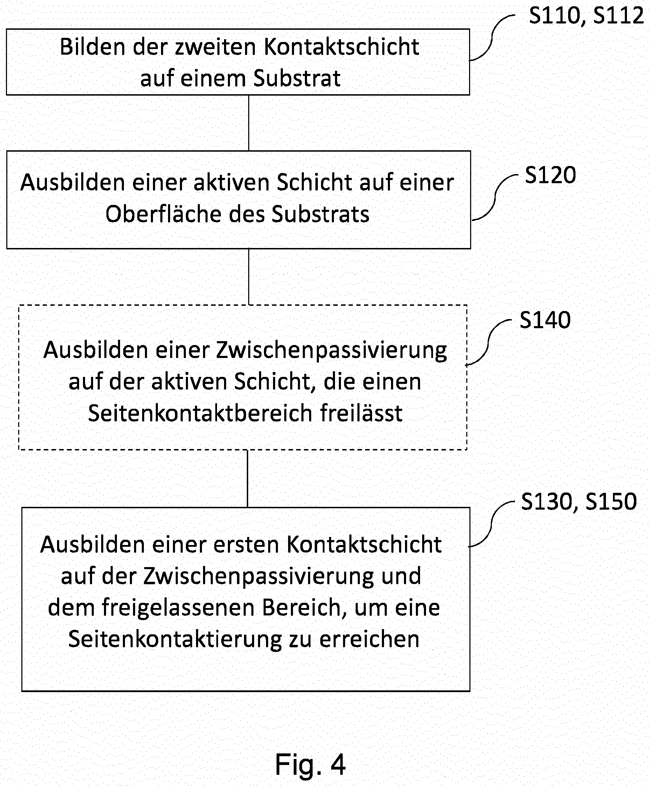

**Fig. 4** zeigt ein Flussdiagramm für ein Verfahren Herstellung einer Gunndiode nach einem Ausführungsbeispiel. Das Verfahren umfasst die Schritte (optional Schritte sind gestrichelt dargestellt):
- Bilden S112 (und somit das Bereitstellen S110) der zweiten Kontaktschicht 120 auf einem Substrat 140;
- Ausbilden S120 einer aktiven Schicht 130 auf einer Oberfläche des Substrats 140, die gegenüberliegend zu der zweiten Kontaktschicht 120 ist, wobei die zweite Kontaktschicht 120 einen elektrischen Kontakt für eine Grundfläche der aktiven Schicht 130 bildet;
- Ausbilden S140 einer Zwischenpassivierung 150 auf der aktiven Schicht 130, wobei ein Seitenkontaktbereich 115 freigelassen wird,
- Ausbilden S130, S150 einer ersten Kontaktschicht 110 auf der Zwischenpassivierung 150 und dem freigelassenen Bereich, um einen Seitenkontakt 115 auszubilden, sodass ein Maximum der elektrische Feldstärke beim Anlegen einer elektrischen Spannung zwischen der ersten Kontaktschicht 110 und der zweiten Kontaktschicht 120 an dem Seitenkontakt 115 sich bildet.

Außerdem kann das Verfahren ein Ausbilden einer Substratpassivierung (154) umfassen, die seitlich neben der aktiven Schicht (130) zwischen der ersten Kontaktschicht (110) und dem Substrat (140) gebildet ist (zum Beispiel, wenn die Kontaktschicht (110) über die Grundfläche 132 geht und einen Kurzschluss bewirken kann).

Alle weiteren zuvor beschriebenen Strukturen können durch weitere optionale Verfahrensschritte Bestandteil dieses Herstellungsverfahrens sein.

Gemäß Ausführungsbeispielen kann der Kontakt zwischen der ersten Kontaktschicht 110 und der aktiven Schicht 130 beispielhaft ein ohmscher Kontakt oder auch ein Schottky-Kontakt sein. Bei dem ohmschen Kontakt ist der Übergang zwischen der ersten Kontaktschicht 110 und dem Halbleitermaterial der aktiven Schicht 130 (z.B. ein Galliumnitrid-basiertes Material) unscharf ausgebildet, während bei einem Schottky-Kontakt eine scharfe Grenzfläche zwischen der Metallisierung und dem Halbleitermaterial erzeugt wird. Der physikalische Unterschied zwischen beiden Kontakten ist, dass der Schottky-Kontakt ein Gleichrichtwirkung zeigt (ähnlich einer Diode) und der ohmsche Kontakt sich wie ein ohmscher Widertand verhält.

Die erste Kontaktschicht 110 und/oder die zweite Kontaktschicht kann/können beispielsweise durch eine Schichtfolge Ti:Al:Ti:Au erzeugt werden. Jedoch kann auch jede beliebige andere Metallisierung genutzt werden, um den elektrischen Kontakt herzustellen. Die zweite Kontaktschicht 120 kann ebenfalls durch einen hochdotierten Bereich des Substrats 140 gebildet sein. Zum Beispiel kann das Substrat 140 ein Galliumnitrid-Substrat sein, sodass die zweite Kontaktschicht 120 durch einfach Rückseitendotierung mit einem gewünschten Dotierprofil erzeugt werden kann. Beispielhaft kann die zweite Kontaktschicht 120 eine Dicke von bis zu 100 nm aufweisen. Die hochdotierten Bereiche des leitfähigen Bereiches 138 und/oder der zweiten Kontaktschicht 120 können beispielsweise in einer Dotierung von bis zu 10¹⁸ cm⁻³ oder mehr erzeugt werden.

Die Passivierung(en) 150, 154 können beispielsweise durch eine Plasmaabscheidung (z. B. PECVD) oder eine andere Möglichkeit hergestellt werden, die eine zuverlässige elektrische Isolierung sicherstellt. Optional kann auch eine isolierende Diamantpassivierung mit guter Wärmeleitfähigkeit benutzt werden.

Gemäß weiteren Ausführungsbeispielen ist es ebenfalls möglich, die Laserbestrahlung 50 von unten oder von einer Seite durchzuführen. Beispielsweise können elektrische Kontakte 110, 120 durch durchsichtiges Material hergestellt werden, so dass die Laserbestrahlung 50 durch die Kontaktschichten 110, 120 hindurch erfolgen kann. Ebenso können die Passivierung(en) 154, 150 transparent sein, so dass die Passivierung(en) ebenfalls genutzt werden können, um die Laserbestrahlung zu dem Bereich der Gunndiode hinzuführen bzw. dort hindurch zu strahlen.

Das Substrat 140 kann beispielhaft eine Dicke von 300 µm aufweisen. Die aktive Schicht 130 kann beispielhaft eine Schichtdicke von 2,5 µm aufweisen, oder aber auch deutlich geringer gewählt werden.

Gemäß weiteren Ausführungsbeispielen werden die erste Kontaktschicht 110 und die zweite Kontaktschicht 120 mit einer integrierten breitbandigen Antenne verbunden, die mit einer breitbandigen THz-Strahlung, ob mit oder ohne gepulste Laserbestrahlung, gespeist wird. Somit werden vielfältige bildgebende und spektroskopische Anwendungen (z.B. Scanner) in THz-Frequenzbereich ermöglicht. Insbesondere werden THz-Frequenzen in Ausgangsleistungen erzeugbar, die viel höher sind, als es für konventionelle Galliumarsenid-basierte Gunndioden bzw. für die InP-Gunndioden möglich wäre. Optional ist auch eine integrierte schmalbandige Antenne möglich, um monochromatische THz-Strahlung mit oder ohne gepulste Laserbestrahlung zu erzeugen.

Im Gegensatz zu konventionellen GaN-basierten Transistoren dienen die Seitenkontakte 115 gemäß Ausführungsbeispielen nicht als Gate-Kontakte zur Modulation des Hauptkanals (Hauptstrompfad) zwischen Kathode und Anode. Die Seitenkontakte 115 können vielmehr als erste Hauptelektrode (Kathode) und die zweite, untere Kontaktschicht 120 als zweite Hauptelektrode (Anode) dienen. Gemäß Ausführungsbeispielen ist somit der Hauptkanal (siehe Fig. 2 und Fig. 3) nicht zwischen zwei gegenüberliegenden Seiten ausgebildet, sondern zwischen dem Seitenkontakt 115 und der zweiten Kontaktschicht 120. Mit der Zwischenpassivierung 150 zwischen der Vorderfläche 137 und der ersten Kontaktschickt 110 wird erreicht, dass die erste Kontaktschickt 110 die aktive Schicht 130 nur entlang der Seitenfläche 135 elektrisch kontaktiert. Der Hauptstrompfad verbindet die Seitenkontakte 115 mit der zweiten Kontaktschicht 140 und verläuft dabei durch das beispielhafte Substrat 140.

Ein Vorteil der Seitenkontaktierung besteht in dem sogenannten negativen differenziellen Widerstand, dessen Erzeugung erleichtert wird und dadurch der Gunn-Effekt unterstützt wird. Außerdem haben Ausführungsbeispiele nicht die Kontaktierungsprobleme, wie sie bei konventionellen Gunndioden vorhanden sind, da ein großer Kontakt seitlich der Diode genutzt wird. Hierdurch wird ein stabiler Kontakt möglich. Außerdem können kleine Dioden erzeugt werden, die eine bessere Wärmesenke und dadurch eine erhöhte Stabilität der Gunndiode ermöglichen. Schließlich ist eine sehr einfache Laserbestrahlung 50 mit dem Seitenkontakt 115 möglich, da der Laser die Diode von oben (z.B. durch das optische Fenster 160) bestrahlen kann.

Ausführungsbeispiele erlauben sehr kleine Dioden (wegen der sehr kleinen effektiven Dicke der Dioden), welches bei konventionellen Dioden mit einem stabilen Kontakt nur schwer möglich ist. Zum Beispiel kann anstatt der 2,5 µm-dicken Standarddiode eine sehr viel kleinere Diodendicke realisiert werden. Durch die Seitenkontaktierung wird außerdem ein kleinerer effektiver Diodenquerschnitt proportional zu a erreicht und eine kleinere effektive Diodendicke d (siehe Fig. 2). Deshalb ist die höchste elektrische Feldstärke in dem Stromkanal nur an den Rändern vorhanden.

Mit diesem Ansatz sind gemäß Ausführungsbeispielen stabile Dioden herstellbar, in die nicht der gesamte Diodenquerschnitt genutzt wird, sondern nur der Seitenbereich 135. Durch Verwendung der kleinen Fläche wird außerdem die Stabilität verbessert. Die Diode ist am Seitenkontakt 115 effektiv am dünnsten, so dass der Gunn-Effekt in diesem Seitenkanal bereits bei kleinen Spannungen (im Vergleich zu anderen Bereichen) auftritt. In den längeren Bereichen verursacht die Spannung nur einen parasitären Stromfluss, der für den Gunn-Effekt weiter nicht von Bedeutung ist.

Alternativ ist es ebenfalls möglich, die Diodenfläche zu passivieren, wie es in dem Ausführungsbeispiel der Fig. 2A gezeigt ist. Hierbei werden die parasitären Ströme reduziert. Eine weitere Möglichkeit gemäß weiteren Ausführungsbeispielen besteht in der Verwendung einer zusätzlichen, optionalen Laserbestrahlung 50, wie sie in der Fig. 3 dargestellt ist. Der Laser wird dabei genutzt, um den Gunn-Effekt zu erleichtern.

Die in der Beschreibung, den Ansprüchen und den Figuren offenbarten Merkmale der Erfindung können sowohl einzeln als auch in beliebiger Kombination für die Verwirklichung der Erfindung wesentlich sein. Der Schutzbereich des Patents wird durch die Patentansprüche bestimmt.

### BEZUGSZEICHENLISTE

- 50: Laserbestrahlung
- 110: erste (obere) Kontaktschicht
- 115: Seitenkontakt
- 120: zweite (untere) Kontaktschicht
- 130: aktive Schicht (GaN)
- 132: Grundfläche
- 135: Seitenfläche
- 137: Vorderfläche
- 138: leitfähiger Bereich
- 140: Substrat
- 150: Zwischenpassivierung
- 154: Substratpassivierung
- 160: optisches Fenster

## Patentansprüche

1. Gunndiode mit:
einer ersten Kontaktschicht (110) und einer zweiten Kontaktschicht (120);
einer aktiven Schicht (130) basierend auf einem Galliumnitrid (GaN)-Halbleitermaterial mit einer Grundfläche (132) und einer dazu gegenüberliegenden Vorderfläche (137) und einer dazu nicht-parallelen Seitenfläche (135), wobei die zweite Kontaktschicht (120) einen elektrischen Kontakt für die Grundfläche (132) bildet, und
wobei die erste Kontaktschicht (110) die Seitenfläche (135) elektrisch kontaktiert, um einen Seitenkontakt (115) zu bilden, sodass ein Maximum der elektrischen Feldstärke beim Anlegen einer elektrischen Spannung zwischen der ersten Kontaktschicht (110) und der zweiten Kontaktschicht (120) an dem Seitenkontakt (115) sich bildet; und
eine Zwischenpassivierung (150) zwischen der Vorderfläche (137) und der ersten Kontaktschicht (110).

2. Gunndiode nach Anspruch 1, die weiter Folgendes umfasst:
ein Substrat (140), das zwischen der zweiten Kontaktschicht (120) und der Grundfläche (132) ausgebildet ist und insbesondere Galliumnitrid aufweist.

3. Gunndiode nach Anspruch 1 oder Anspruch 2, wobei die aktive Schicht (130) entlang einer der Grundfläche (132) gegenüberliegenden Vorderfläche (137) einen elektrisch leitfähigen Bereich (138) aufweist, der insbesondere durch einen höher dotierten Bereich gebildet wird.

4. Gunndiode nach einem der vorhergehenden Ansprüche,
wobei die Seitenfläche (135) abgeschrägt oder senkrecht zur Grundfläche (132) ausgebildet ist und die Grundfläche (132) mit der Vorderfläche (137) verbindet.

5. Gunndiode nach Anspruch 4, wobei die folgende Passivierung (154) ausgebildet ist:
- eine Substratpassivierung (154), die seitlich neben der aktiven Schicht (130) zwischen der ersten Kontaktschicht (110) und dem Substrat (140) gebildet ist.

6. Gunndiode nach einem der vorhergehenden Ansprüche, wobei die erste Kontaktschicht (110) die aktive Schicht (130) nur entlang der Seitenfläche (135) elektrisch kontaktiert.

7. Gunndiode nach einem der vorhergehenden Ansprüche, wobei ein optisches Fenster (160) als optischen Zugang zur Vorderfläche (137) ausgebildet ist, um optische Anregungen im Bereich des Seitenkontaktes (115) zu ermöglichen oder zu unterstützen.

8. Gunndiode nach einem der vorhergehenden Ansprüche, wobei der Seitenkontakt (115) als ein ohmscher Seitenkontakt oder als ein Schottky-Seitenkontakt gebildet ist.

9. Gunndiode nach einem der vorhergehenden Ansprüche, wobei zumindest eine der definierten Schichten eine der folgenden Ausdehnungen hat:
- die aktive Schicht (130) eine Dicke im Bereich von 2 bis 5 µm,
- der leitfähige Bereich (138) eine Dicke im Bereich von 50 - 200 nm,
- das Substrat (140) eine Dicke im Bereich zwischen 250 und 400 µm.

10. Gunndiode nach einem der vorhergehenden Ansprüche, wobei die erste Kontaktschicht (110) und/oder die zweite Kontaktschicht (120) durch eine Schichtfolge mit zumindest einem der folgenden Materialien gebildet ist: Titan, Aluminium, Gold oder als hochdotiertes Halbleitermaterial gebildet ist.

11. Bildgebender Scanner mit einer Gunndiode nach einem der vorhergehenden Ansprüche als THz-Strahlungsquelle.

12. Verfahren zur Herstellung einer Gunndiode mit den folgenden Schritten:
Bereitstellen (S110) einer zweiten Kontaktschicht (120);
Ausbilden (S120) einer aktiven Schicht (130) basierend auf einem Galliumnitrid (GaN)-Halbleitermaterial mit einer Grundfläche (132) und eine dazu gegenüberliegenden Vorderfläche (137) und einer dazu nicht-parallelen Seitenfläche (135), wobei die zweite Kontaktschicht (120) einen elektrischen Kontakt für die Grundfläche bildet; und
Bilden (S130) eines elektrischen Seitenkontaktes (115) zwischen der Seitenfläche (135) und einer ersten Kontaktschicht (110), sodass ein Maximum der elektrischen Feldstärke beim Anlegen einer elektrischen Spannung zwischen der ersten Kontaktschicht (110) und der zweiten Kontaktschicht (120) sich an dem Seitenkontakt (115) bildet,
wobei eine Zwischenpassivierung (150) zwischen der Vorderfläche (137) und der ersten Kontaktschicht (110) ausgebildet wird.

13. Verfahren nach Anspruch 12, das weiter folgende Schritte umfasst:
Bilden (S112) der zweiten Kontaktschicht (120) auf einem Substrat (140), wobei das Ausbilden (S120) einer aktiven Schicht (130) auf einer Oberfläche des Substrats (140) erfolgt, die gegenüberliegend zu der zweiten Kontaktschicht (120) ist;
Ausbilden (S140) einer Zwischenpassivierung (150) auf der aktiven Schicht (140);
Ausbilden (S150) einer ersten Kontaktschicht (110) auf der Zwischenpassivierung (150) und zumindest teilweise auf dem Substrat (140) seitlich neben der aktiven Schicht (140), wobei optional zwischen der ersten Kontaktschicht (110) und dem Substrat (140) seitlich neben der aktiven Schicht (130) eine Substratpassivierung (154) ausgebildet wird.

14. Verfahren nach Anspruch 12 oder Anspruch 13, das weiter Folgendes umfasst:
Freilegen zumindest eines Teils der ersten Kontaktschicht (110) gegenüberliegend der aktiven Schicht (130), um ein optisches Fenster für eine optische Bestrahlung zur Unterstützung der Gunndiode bereitzustellen.

15. Verfahren nach einem der Ansprüche 12 bis 14, das weiter Folgendes umfasst:
Bereitstellen eines Lichtleiters für eine optische Zuleitung von Photonen in die aktive Schicht (130) in einer Umgebung des Seitenkontaktes (115).

## Claims

1. Gunn diode comprising:
a first contact layer (110) and a second contact layer (120);
an active layer (130) based on a gallium nitride (GaN) semiconductor material having a base surface (132) and a front surface (137) opposite the base surface and a lateral surface (135) not parallel thereto, wherein the second contact layer (120) forms an electrical contact for the base surface (132), and
wherein the first contact layer (110) electrically contacts the lateral surface (135) to form a lateral contact (115) such that a maximum of the electrical field strength is formed at the lateral contact (115) when an electrical voltage is applied between the first contact layer (110) and the second contact layer (120); and
an intermediate passivation region (150) between the front surface (137) and the first contact layer (110).

2. Gunn diode according to claim 1, which further comprises the following:
a substrate (140), which is formed between the second contact layer (120) and the base surface (132) and comprises in particular gallium nitride.

3. Gunn diode according to claim 1 or claim 2, wherein the active layer (130) has an electrically conductive region (138) along a front surface (137) opposite the base surface (132), which electrically conductive region is formed in particular by a more highly doped region.

4. Gunn diode according to any of the preceding claims,
wherein the lateral surface (135) is chamfered or perpendicular to the base surface (132) and connects the base surface (132) to the front surface (137).

5. Gunn diode according to claim 4, wherein the following passivation region (154) is formed:
- a substrate passivation region (154) formed laterally next to the active layer (130) between the first contact layer (110) and the substrate (140).

6. Gunn diode according to any of the preceding claims, wherein the first contact layer (110) electrically contacts the active layer (130) only along the lateral surface (135).

7. Gunn diode according to any of the preceding claims, wherein an optical window (160) is provided as optical access to the front surface (137) in order to allow or assist with optical excitations in the region of the lateral contact (115).

8. Gunn diode according to any of the preceding claims, wherein the lateral contact (115) is formed as a lateral ohmic contact or as a lateral Schottky contact.

9. Gunn diode according to any of the preceding claims, wherein at least one of the defined layers has one of the following dimensions:
- the active layer (130) has a thickness in the range of 2 to 5 µm,
- the conductive region (138) has a thickness in the range of 50 - 200 nm,
- the substrate (140) has a thickness in the range between 250 and 400 µm.

10. Gunn diode according to any of the preceding claims, wherein the first contact layer (110) and/or the second contact layer (120) is formed by a layer sequence comprising at least one of the following materials: titanium, aluminum, gold, or is in the form of a highly doped semiconductor material.

11. Imaging scanner comprising a Gunn diode according to any of the preceding claims as a THz radiation source.

12. Method for manufacturing a Gunn diode, comprising the following steps:
providing (S110) a second contact layer (120);
forming (S120) an active layer (130), which is based on a gallium nitride (GaN) semiconductor material and has a base surface (132) and a front surface (137) opposite the base surface and a lateral surface (135) not parallel thereto, wherein the second contact layer (120) forms an electrical contact for the base surface; and
forming (S130) a lateral electrical contact (115) between the lateral surface (135) and a first contact layer (110) such that a maximum of the electrical field strength is formed at the lateral contact (115) when an electrical voltage is applied between the first contact layer (110) and the second contact layer (120),
wherein an intermediate passivation region (150) is formed between the front surface (137) and the first contact layer (110).

13. Method according to claim 12, which further comprises the following:
forming (S112) the second contact layer (120) on a substrate (140), wherein the formation (S120) of an active layer (130) takes place on a surface of the substrate (140) which is opposite the second contact layer (120);
forming (S140) an intermediate passivation region (150) on the active layer (140);
forming (S150) a first contact layer (110) on the intermediate passivation region (150) and at least in part on the substrate (140) laterally next to the active layer (140), wherein a substrate passivation region (154) is optionally formed between the first contact layer (110) and the substrate (140) laterally next to the active layer (130).

14. Method according to claim 12 or claim 13, which further comprises the following:
exposing at least part of the first contact layer (110) opposite the active layer (130) in order to provide an optical window for optical irradiation for assisting the Gunn diode.

15. Method according to any of claims 12 to 14, which further comprises the following:
providing a waveguide for optically supplying photons into the active layer (130) in a vicinity of the lateral contact (115).

## Revendications

1. Diode Gunn comportant :
une première couche de contact (110) et une seconde couche de contact (120) ;
une couche active (130) à base d'un matériau semi-conducteur en nitrure de gallium (GaN), comportant une face de base (132), une face avant (137) opposée à celle-ci et une face latérale (135) non parallèle à celle-ci, dans laquelle la seconde couche de contact (120) forme un contact électrique pour la face de base (132), et
dans laquelle la première couche de contact (110) établit un contact électrique avec la face latérale (135) afin de former un contact latéral (115), de sorte qu'un maximum d'intensité de champ électrique se forme au niveau du contact latéral (115) lors de l'application d'une tension électrique entre la première couche de contact (110) et la seconde couche de contact (120) ; et
une passivation intermédiaire (150) entre la face avant (137) et la première couche de contact (110).

2. Diode Gunn selon la revendication 1, laquelle comprend en outre ce qui suit :
un substrat (140), qui est réalisé entre la seconde couche de contact (120) et la face de base (132) et présente notamment du nitrure de gallium.

3. Diode Gunn selon la revendication 1 ou la revendication 2, dans laquelle la couche active (130) présente, le long d'une face avant (137) opposée à la face de base (132), une zone électroconductrice (138) qui est notamment formée par une zone plus fortement dopée.

4. Diode Gunn selon l'une des revendications précédentes,
dans laquelle la face latérale (135) est biseautée ou perpendiculaire à la face de base (132) et relie la face de base (132) à la face avant (137).

5. Diode Gunn selon la revendication 4, dans laquelle la passivation (154) suivante est réalisée :
- une passivation de substrat (154), qui est formée latéralement à côté de la couche active (130), entre la première couche de contact (110) et le substrat (140).

6. Diode Gunn selon l'une des revendications précédentes, dans laquelle la première couche de contact (110) établit un contact électrique avec la couche active (130) uniquement le long de la face latérale (135).

7. Diode Gunn selon l'une des revendications précédentes, dans laquelle une fenêtre optique (160) est réalisée comme accès optique à la face avant (137) afin de permettre ou de soutenir des excitations optiques dans la zone du contact latéral (115).

8. Diode Gunn selon l'une des revendications précédentes, dans laquelle le contact latéral (115) est formé comme un contact latéral ohmique ou un contact latéral de type Schottky.

9. Diode Gunn selon l'une des revendications précédentes, dans laquelle au moins l'une des couches définies a l'une des dimensions suivantes :
- la couche active (130) une épaisseur dans la plage de 2 à 5 µm,
- la zone conductrice (138) une épaisseur dans la plage de 50 à 200 nm,
- le substrat (140) une épaisseur dans la plage de 250 à 400 µm.

10. Diode Gunn selon l'une des revendications précédentes, dans laquelle la première couche de contact (110) et/ou la seconde couche de contact (120) sont formées d'une succession de couches comportant au moins l'un des matériaux suivants : titane, aluminium, or ou est formé comme matériau semi-conducteur fortement dopé.

11. Scanner d'imagerie comportant une diode Gunn selon l'une des revendications précédentes comme source de rayonnement THz.

12. Procédé de fabrication d'une diode Gunn comportant les étapes suivantes :
fourniture (S110) d'une seconde couche de contact (120) ;
réalisation (S120) d'une couche active (130) à base d'un matériau semi-conducteur de nitrure de gallium (GaN), comportant une face de base (132), une face avant (137) opposée à celle-ci et une face latérale (135) non parallèle à celle-ci, dans lequel la seconde couche de contact (120) forme un contact électrique pour la face de base ; et
formation (S130) d'un contact latéral électrique (115) entre la face latérale (135) et une première couche de contact (110), de sorte qu'un maximum d'intensité de champ électrique se forme au niveau du contact latéral (115) lors de l'application d'une tension électrique entre la première couche de contact (110) et la seconde couche de contact (120),
dans lequel une passivation intermédiaire (150) est réalisée entre la face avant (137) et la première couche de contact (110).

13. Procédé selon la revendication 12, lequel comprend en outre les étapes suivantes :
formation (S112) de la seconde couche de contact (120) sur un substrat (140), dans lequel la réalisation (S120) d'une couche active (130) s'effectue sur une surface du substrat (140) qui est opposée à la seconde couche de contact (120) ;
réalisation (S140) d'une passivation intermédiaire (150) sur la couche active (140) ;
réalisation (S150) d'une première couche de contact (110) sur la passivation intermédiaire (150) et au moins partiellement sur le substrat (140), latéralement à côté de la couche active (140), dans lequel une passivation de substrat (154) est réalisée, éventuellement, entre la première couche de contact (110) et le substrat (140), latéralement à côté de la couche active (130).

14. Procédé selon la revendication 12 ou la revendication 13, lequel comprend en outre ce qui suit :
mise à nu d'au moins une partie de la première couche de contact (110) opposée à la couche active (130), afin de fournir une fenêtre optique permettant un rayonnement optique destiné à soutenir la diode Gunn.

15. Procédé selon l'une des revendications 12 à 14, lequel comprend en outre ce qui suit :
fourniture d'un guide de lumière pour un acheminement optique de photons dans la couche active (130) dans un environnement du contact latéral (115).
